# EUROPEAN PATENT APPLICATION

(11) **EP 4 527 617 A1**
(43) Date of publication of application: **26.03.2025**
(21) Application number: 24202427.1
(22) Date of filing: 25.09.2024
(51) Int. Cl.: B32B 15/20, C08F 4/14, C08F 8/20, C08F 212/08, C08F 212/12, C09D 125/18

(54) **HYDROCARBON RESIN POLYMER AND MANUFACTURING METHOD THEREOF AND SUBSTRATE STRUCTURE**

(30) Priority: 25.09.2023 US 202363585037 P; 09.09.2024 TW 113134063
(71) Applicant: LCY Chemical Corp., Kaohsiung City 812 (TW)
(72) Inventor: CHEN, Chien-Han, 812 Kaohsiung City (TW); LEE, Wei-Liang, 812 Kaohsiung City (TW); LIAO, Ming-Hung, 812 Kaohsiung City (TW); CHEN, Yu-Tien, 812 Kaohsiung City (TW); HSU, Yu-Chen, 812 Kaohsiung City (TW); AU-YEUNG, Ka-Chun, 812 Kaohsiung City (TW); HUANG, Chiung-Yao, 812 Kaohsiung City (TW); HUANG, Tzu-Yin, 812 Kaohsiung City (TW); TANG, Yi-Hsuan, 812 Kaohsiung City (TW)
(74) Representative: Fuchs Patentanwälte Partnerschaft mbB

(57) **Abstract**

A hydrocarbon resin polymer including a repeating unit (A) is derived from dicyclopentadiene (DCPD). The hydrocarbon resin polymer has a fluorine substituent, and the content of the fluorine substituent is 100 to 4500 ppm based on the total weight of the hydrocarbon resin polymer. A manufacturing method of the above hydrocarbon resin polymer. The manufacturing method includes polymerizing a mixture in the presence of a fluorine-containing compound, wherein the fluorine-containing compound is a boron trifluoride complex and the mixture includes a dicyclopentadiene. A substrate structure includes a resin layer, and a conductive layer disposed on the resin layer. The resin layer is formed from a resin composition including the above hydrocarbon resin polymer using a cross-linking process.

## Description

### CROSS REFERENCE TO RELATED APPLICATIONS

This application claims the benefit of U.S. Provisional Application No. 63/585,037, filed on September 25, 2023 and also claims the benefit of Taiwan Application No. 113,134,063 filed on September 9, 2024, the entirety of which is incorporated by reference herein.

### BACKGROUND

### Technical Field

The present disclosure is related to a resin polymer, a manufacturing method thereof, and a substrate structure. More particularly, it is related to a hydrocarbon resin polymer, a manufacturing method thereof, and a substrate structure.

### Description of the Related Art

5th generation mobile network technology (5G mobile networks, for short) is the latest generation of mobile communication technology. 5G mobile communication technology has the characteristics of high-speed transmission, extensive connectivity, and low latency. 5G mobile communication technology can be divided into three types, depending on the frequency band used: high-frequency 5G, intermediate-frequency 5G, and low-frequency 5G. High-frequency 5G can provide ultra-fast connection speeds.

The signal emission and reception quality of high-frequency 5G may be affected by high-frequency path loss, conductor loss, and dielectric loss during the signal transmission process, however. Therefore, there is a need to develop a low dielectric loss Copper Clad Laminate (CCL) material to minimize dielectric loss during the signal transmission process in high frequency 5G and improve the signal emission and reception quality of high-frequency 5G.

Reducing dielectric loss can be achieved by reducing the dielectric properties (dielectric constant (Dk) and the dielectric loss tangent (Df)) of the copper clad laminate (CCL) material. Hydrocarbon resins or polyolefin materials composed of carbon atoms and hydrogen atoms have low dielectric loss characteristics due to the small number of polar functional groups. However, hydrocarbons are susceptible to oxidation due to heating processes during the manufacturing process. The electrical performance of the oxidized hydrocarbon resin will deteriorate (i.e., the dielectric constant and the dielectric loss tangent will be increased).

A fluorine substituent is known to impart two important properties to resins: hydrophobicity and electron-withdrawing ability. These two properties have a significant effect on the dielectric properties of the resins. In particular, the fluorine substituent increases the hydrophobicity of the resins by reducing the surface energy. Hydrophobicity contributes to a material's resistance to water and dirt, making it suitable for use in an electronic element to prevent the effects of moisture on the element's dielectric properties. In addition, the electron-withdrawing ability of the fluorine substituent reduces the polarizability of the material, which in turn reduces the dielectric constant and dielectric loss of the material, making resins having the fluorine substituent excellent for high-frequency applications, helping to improve the speed and stability of signal transmission.

### SUMMARY

In view of the problems described above, the present disclosure provides a hydrocarbon resin polymer having a fluorine substituent and a manufacturing method thereof. The hydrocarbon resin polymer of the present disclosure has good electrical performance. A substrate structure having a resin layer formed by crosslinking a resin composition including the hydrocarbon resin polymer of the present disclosure can also have good electrical performance.

In some embodiments, the present disclosure provides a hydrocarbon resin polymer including a repeating unit (A) derived from a dicyclopentadiene (DCPD). The hydrocarbon resin polymer has fluorine substituents, and the content of the fluorine substituents is 100 to 4500 ppm based on the total weight of the hydrocarbon resin polymer.

In some embodiments, the present disclosure provides a manufacturing method of a hydrocarbon resin polymer. The manufacturing method includes polymerizing a mixture in the presence of a fluorine-containing compound, wherein the fluorine-containing compound is a boron trifluoride complex and the mixture includes a dicyclopentadiene.

In some embodiments, the present disclosure provides a substrate structure. The substrate structure includes a resin layer, and a conductive layer disposed on the resin layer. The resin layer is formed from a resin composition including a hydrocarbon resin polymer using a cross-linking process. The hydrocarbon resin polymer has fluorine substituents and includes a repeating unit (A) derived from a dicyclopentadiene (DCPD), wherein the content of the fluorine substituents is 100 to 4500 ppm based on the total weight of the hydrocarbon resin polymer.

### BRIEF DESCRIPTION OF THE DRAWINGS

Embodiments, purposes, features and advantages of the present disclosure can be best understood from the following detailed description in conjunction with the accompanying drawings.
FIG. 1 is a schematic view of a substrate structure according to an embodiment of the present disclosure.
FIG. 2 is the ¹⁹F NMR spectrum of a hydrocarbon resin polymer according to an embodiment of the present disclosure.

### DETAILED DESCRIPTION

It will be further understood that the terms "comprises," and/or "includes" when used herein, specify the presence of stated features, integers, steps, operations, elements, components and/or groups thereof, but do not preclude the presence or addition of one or more other features, integers, steps, operations, elements, components and/or groups thereof. As used herein, the singular forms "a," "an" and "the" are intended to include the plural forms as well, unless the context clearly indicates otherwise.

It will be understood that, although the terms "first," "second," etc. may be used herein to describe various elements, components, regions, layers and/or portions, these elements, components, regions, layers and/or portions should not be limited by these terms. These terms are used to distinguish one element, component, region, layer or portion from another element, component, region, layer or portion.

It will be understood that, the term "about," "approximate," "rough" as used herein usually indicates a value of a given value or range that varies within 20%, preferably within 10%, and preferably within 5%, or within 3%, or within 2%, or within 1%, or within 0.5%. The value given here are approximate value, i.e., "about," "approximate," or "rough" may be implied without specifying "about," "approximate," or "rough." It will be further understood that the values indicated in herein may include the said values as well as deviation values that are within an acceptable deviation range for people having general knowledge in art. It will be understood that the expression "a-b" used herein to indicate a specific range of values is defined as "≧a and ≦b."

Unless otherwise defined, all terms (including technical and scientific terms) used herein have the same meaning as commonly understood by a person skilled in the art to which the invention pertains. It will be further understood that terms, such as those defined in commonly used dictionaries, should be interpreted as having a meaning consistent with the relevant technology and the context or background of this disclosure and will not be interpreted in an idealized or overly formal sense unless expressly so defined herein. Descriptions of known functions and constructions that may unnecessarily obscure the present disclosure will be omitted below.

The term "C₁₋₂₀ alkyl group" used herein refers to a linear, branched, or cyclic aliphatic hydrocarbon monovalent group having 1 to 20 carbon atoms in the main carbon chain. Examples of the C₁₋₂₀ alkyl group include, but are not limited to, a methyl group, an ethyl group, a propyl group, an iso-butyl group, a sec-butyl group, a tert-butyl group, a pentyl group, an iso-amyl group, a hexyl group, a decyl group, a dodecyl group, a cyclohexyl group, a cyclooctyl group, and a cyclododecyl group, but the present disclosure is not limited thereto.

Some embodiments of the present disclosure provide a hydrocarbon resin polymer. The hydrocarbon resin polymer includes a repeating unit (A) derived from a dicyclopentadiene (DCPD). The hydrocarbon resin polymer has fluorine substituents, and the content of the fluorine substituents is 100 to 4500 ppm based on the total weight of the hydrocarbon resin polymer. When the content of the fluorine substituents in the hydrocarbon resin polymer is within the above range, the hydrocarbon resin polymer can have better electrical properties. The term "content of the fluorine substituents" in the present disclosure is calculated based on the ¹⁹F NMR spectrum of the hydrocarbon resin polymer using trifluorotoluene (TFT) as an internal standard. Specifically, the "content of the fluorine substituents" in the present disclosure is calculated using the following formula: Content of the fluorine substituents (ppm)=(trifluorotoluene (g))/146.11×19×Integral value of fluoride ions ÷ Weight of the hydrocarbon resin polymer(g)×1,000,000, The integral value of the fluoride ions in the formula above is the sum of areas of all peaks in a range of -125 ppm to -230 ppm in the ¹⁹F NMR spectrum of the hydrocarbon resin polymer using trifluorotoluene (TFT) as an internal standard.

In some embodiments, the repeating unit (A) may have the following structures, but the present disclosure is not limited thereto: 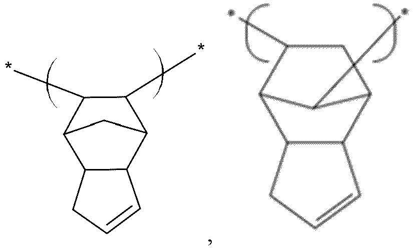 ,or 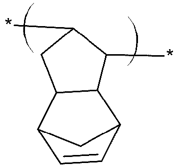 In some embodiments, the repeating unit (A) may have fluorine substituents (not shown).

The "*" in the structures above indicates a position where it is connected to other groups or units. Compared with a linear repeating unit, the repeating unit (A) derived from a dicyclopentadiene (DCPD) has higher rigidity. Therefore, the glass transition temperature of the hydrocarbon resin polymer can be increased or the thermal property of the hydrocarbon resin polymer can be improved.

In some embodiments, a number average molecular weight (Mn) of the hydrocarbon resin polymer may be in a range of 500 to 15,000 g/mol. If the number average molecular weight of the hydrocarbon resin polymer is too high, a solubility of the hydrocarbon resin polymer will decrease. In some embodiments, the number average molecular weight of the hydrocarbon resin polymer may be from 700 to 15,000 g/mol, from 800 to 14,000 g/mol, or from 900 to 13,000 g/mol.

The average number of fluorine substituents per molecule of the hydrocarbon resin polymer of the present disclosure can be calculated based on the content of the fluorine substituents of the hydrocarbon resin polymer of the present disclosure and the number average molecular weight of the hydrocarbon resin polymer of the present disclosure. Specifically, the average number of fluorine substituents per molecule of the hydrocarbon resin polymer in the present disclosure is calculated using the following formula: Average number of fluorine substituents per molecule of the hydrocarbon resin polymer =(( Content of the fluorine substituents (ppm)× 0.001)/19/(1000/(Number average molecular weight of the hydrocarbon resin polymer (g/mol)))

Based on the above formula, the hydrocarbon resin polymer of the present disclosure is calculated to have an average of 0.02 to 2 fluorine substituents per molecule. In some embodiments, the hydrocarbon resin polymer of the present disclosure has an average of 0.03 to 1.5 fluorine substituents, 0.03 to 1.0 fluorine substituents, 0.03 to 0.8 fluorine substituents, 0.03 to 0.5 fluorine substituents per molecule. When the hydrocarbon resin polymer of the present disclosure has an average within the above range of fluorine substituents per molecule, the hydrocarbon resin polymer can have better electrical performance.

In some embodiments, the hydrocarbon resin polymer may have a polymer dispersity index (PDI) of less than 22. When the polymer dispersion index of the hydrocarbon resin polymer is less than 22, the hydrocarbon resin polymer will have a better processability. In some embodiments, the hydrocarbon resin polymer may have a polymer dispersion index greater than 1.5. In some embodiments, the polymer dispersion index of the hydrocarbon resin polymer may be 1.5 to 20, 2 to 18, or 2.2 to 16.5.

In some embodiments, the hydrocarbon resin polymer of the present disclosure may include a repeating unit (B) derived from a monovinyl aromatic compound and a repeating unit (C) derived from a divinyl aromatic compound.

Herein, the monovinyl aromatic compound refers to a compound that includes a carbocyclic aromatic structure, and one hydrogen on the ring carbon atom of the carbocyclic aromatic structure is replaced by a vinyl group. In some embodiments, the vinyl group may be unsubstituted. In some embodiments, at least one hydrogen atom on the vinyl group may be replaced by a C₁₋₂₀ alkyl group. In some embodiments, the carbocyclic aromatic structure may include 6 to 60 or 6 to 20 ring carbon atoms. In some embodiments, the carbocyclic aromatic structure may be unsubstituted. In some embodiments, at least one hydrogen on the ring carbon atom in the carbocyclic aromatic structure may be replaced by a C₁₋₂₀ alkyl group. Examples of the monovinyl aromatic compound may include styrene, methyl styrene, or ethyl styrene, but the present disclosure is not limited thereto.

The repeating unit (B) derived from the monovinyl aromatic compound includes a carbocyclic aromatic structure derived from the monovinyl aromatic compound. For example, in some embodiments, the repeating unit (B) may have the following structure, but the present disclosure is not limited thereto: 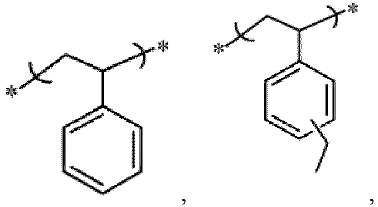 or 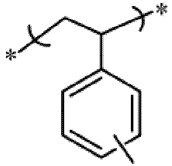 The "*" in the structure above indicates the position where it is connected to other groups or units.

Herein, the divinyl aromatic compound refers to a compound that includes a carbocyclic aromatic structure, and two hydrogens on the ring carbon atom of the carbocyclic aromatic structure are replaced by vinyl groups. In some embodiments, the vinyl groups may be unsubstituted. In some embodiments, at least one hydrogen atom on the vinyl groups may be replaced by a C₁₋₂₀ alkyl group. In some embodiments, the carbocyclic aromatic structure may include 6 to 60 or 6 to 20 ring carbon atoms. In some embodiments, the carbocyclic aromatic structure may be unsubstituted. In some embodiments, at least one hydrogen on the ring carbon atom of the carbocyclic aromatic structure may be replaced by a C₁₋₂₀ alkyl group. Examples of the divinyl aromatic compound may include divinylbenzene or diisopropenylbenzene (IPAMS), but the present disclosure is not limited thereto.

The repeating unit (C) derived from the divinyl aromatic compound includes a carbocyclic aromatic structure derived from the divinyl aromatic compound. In some embodiments, the repeating unit (C) may include a cross-linkable repeating unit (C1) and a cross-linked repeating unit (C2): 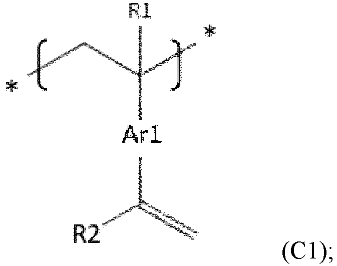 and

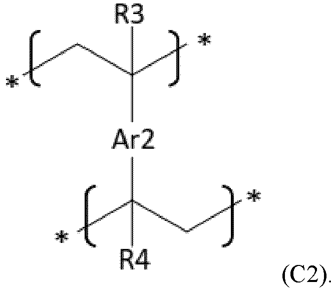

R1, R2, R3, and R4 in the cross-linkable repeating unit (C1) and the cross-linked repeating unit (C2) may each be independently H or a C₁₋₂₀ alkyl group, and Ar1 and Ar2 may be a phenylene group. The "*" indicates the connecting position between the cross-linkable repeating unit (C1) and/or the cross-linked repeating unit (C2) and other groups or units. In some embodiments, the cross-linkable repeating unit (C1) may include a structure as shown below, but the present disclosure is not limited thereto: 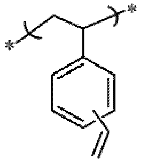 In some embodiments, the cross-linked repeating unit (C2) may include a structure as shown below, but the present disclosure is not limited thereto:

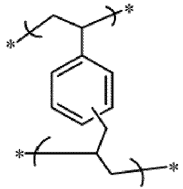

In some embodiments, based on the sum of all units in the hydrocarbon resin polymer being 100 mol%, the hydrocarbon resin polymer may include 0.15 to 15 mol% of repeating unit (A), 14 to 95 mol% of repeating unit (B), and 4 to 85 mol% of repeating unit (C). When the content of the repeating unit (A) in the hydrocarbon resin polymer is within the range provided above, the hydrocarbon resin polymer can have better thermal property and lower manufacturing cost. When the content of the repeating unit (B) and the repeating unit (C) in the hydrocarbon resin polymer is within the range provided above, the hydrocarbon resin polymer may have better thermal properties and/or processability. In some embodiments, based on the sum of all units in the hydrocarbon resin polymer being 100 mol%, the hydrocarbon resin polymer may include 0.15 to 10 mol% of repeating unit (A), 50 to 90 mol% of repeating unit (B), and 8 to 40 mol% of repeating unit (C). In some embodiments, based on the sum of all units in the hydrocarbon resin polymer being 100 mol%, the hydrocarbon resin polymer may include 1 to 8 mol% of repeating unit (A), 60 to 89 mol% of repeating unit (B), and 10 to 30 mol% of repeating unit (C). In some embodiments, based on the sum of all units in the hydrocarbon resin polymer being 100 mol%, the hydrocarbon resin polymer may include 1 to 30 mol% of cross-linkable repeating unit (C1). When the content of the cross-linkable repeating unit (C1) in the hydrocarbon resin polymer is within the above range, the hydrocarbon resin polymer may have good thermal property, electrical performance, and/or processability. In some embodiments, based on the sum of all units in the hydrocarbon resin polymer being 100 mol%, the hydrocarbon resin polymer may include 3 to 28 mol%, 5 to 25 mol%, or 6 to 22 mol% of cross-linkable repeating unit (C1).

The repeating unit (A) and repeating unit (C) will affect the thermal property and thermal stability of the hydrocarbon resin polymer. In some embodiments, based on the sum of all units in the hydrocarbon resin polymer being 100 mol%, the sum of the content of the repeating unit (A) and the repeating unit (C) of the hydrocarbon resin polymer is greater than or equal to 13 mol%. The sum of the content of the repeating unit (A) and the repeating unit (C) greater than or equal to 13 mol% can provide excellent thermal property and thermal stability of the hydrocarbon resin polymer. In some embodiments, based on the sum of all units in the hydrocarbon resin polymer being 100 mol%, the sum of the content of the repeating unit (A) and the repeating unit (C) of the hydrocarbon resin polymer may be greater than or equal to 15 mol%, 17 mol%, or 20 mol%. In some embodiments, based on the sum of all units in the hydrocarbon resin polymer being 100 mol%, the sum of the content of the repeating unit (A) and the repeating unit (C) of the hydrocarbon resin polymer may be less than or equal to 45 mol%, 40 mol%, or 35 mol%.

In some embodiments, the hydrocarbon resin polymer may include a reactive double bond. The "reactive double bond" in the present disclosure refers to a double bond in the repeating unit (A) or repeating unit (C) that can react with other compounds or polymers. For example, in some embodiments, the reactive double bond includes the double bond in the repeating unit (A) shown below: 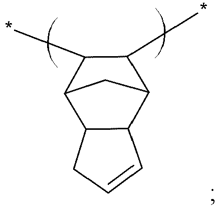 or the double bond in the non-benzene ring of the repeating unit (C) shown below: 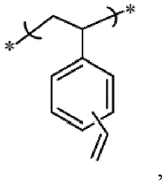 but the present disclosure is not limited thereto.

In some embodiments, the hydrogen content on the reactive double bond in the hydrocarbon resin polymer may be less than 10%. If the hydrogen content on the reactive double bond in the hydrocarbon resin polymer is too high, for example, higher than 10%, the hydrocarbon resin polymer will be easily oxidized during a heating process, resulting in poor electrical performance of the hydrocarbon resin polymer. In some embodiments, the hydrogen content on the reactive double bond in the hydrocarbon resin polymer may be greater than 0.2%. If the hydrogen content on the reactive double bond in the hydrocarbon resin polymer is too low, for example, less than 0.2%, a peel strength of a layer including the hydrocarbon resin polymer may be too low. In some embodiments, the hydrogen content on the reactive double bond in the hydrocarbon resin polymer may be 0.2% to 10%, 0.3% to 9%, 0.4% to 8%, or 0.5% to 7%. When the hydrogen content on the reactive double bond in the hydrocarbon resin polymer is within the above range, the hydrocarbon resin polymer is not easily oxidized in a high temperature environment (for example, above 150°C) or tends to complete the cross-linking reaction before oxidation. Therefore, the electrical performance of the hydrocarbon resin polymer can be improved.

In summary, the hydrocarbon resin polymer of the present disclosure may have good electrical performance (dielectric properties). In some embodiments, the hydrocarbon polymers of the present disclosure may also have good thermal properties or processability.

In some embodiments, the present disclosure provides a manufacturing method of a hydrocarbon resin polymer. The manufacturing method of a hydrocarbon resin polymer of the present disclosure includes polymerizing a mixture in the presence of a fluorine-containing compound, wherein the fluorine-containing compound is a boron trifluoride complex and the mixture includes a dicyclopentadiene.

In some embodiments, the boron trifluoride complex may include boron trifluoride tetrahydrofuran complex (BF₃· THF), boron trifluoride methanol complex (BF₃· MeOH), boron trifluoride hydrate (BF₃· H₂O), boron trifluoride diethyl ether complex (BF₃· OEt₂), boron trifluoride -anisole complex (BF₃ · PhOMe), boron trifluoride acetic acid complex (BF₃· AcOH), or any combination thereof.

In some embodiments, the mole ratio of the fluorine-containing compound: the mixture may be 0.01 to 1:20. When the mole ratio of the fluorine-containing compound: the mixture is within the above range, the manufacturing method of a hydrocarbon resin polymer of the present disclosure has a better polymerization reaction speed, resulting in the hydrocarbon resin polymer having a suitable crosslinking degree and molecular weight and avoids an occurrence of gelling phenomenon. In some embodiments, the mole ratio of the fluorine-containing compound: the mixture may be 0.05 to 1:20, 0.08 to 0.9:20, or 0.1 to 1:20.

The mixture may further include a monovinyl aromatic compound and/or a divinyl aromatic compound. That is, in some embodiments, the mixture may include a dicyclopentadiene and a monovinyl aromatic compound; a dicyclopentadiene and a divinyl aromatic compound; or a dicyclopentadiene, a monovinyl aromatic compound, and a divinyl aromatic compound.

In some embodiments, based on the sum of all components in the mixture being 100 mol%, the mixture include 3 to 80 mol% of dicyclopentadiene, 0 to 90 mol% of monovinyl aromatic compound, and 0 to 50 mol% of divinyl aromatic compound. In some embodiments, based on the sum of all components in the mixture being 100 mol%, the mixture include 3.5 to 70 mol% of dicyclopentadiene, 20 to 88 mol% of the monovinyl aromatic compound, and 0.05 to 35 mol% of the divinyl aromatic compound. In some embodiments, based on the sum of all components in the mixture being 100 mol%, the mixture include 4 to 60 mol% of dicyclopentadiene, 25 to 87 mol% of the monovinyl aromatic compound, and 0.06 to 25 mol% of the divinyl aromatic compound. The definitions and examples of the monovinyl aromatic compound and the divinyl aromatic compound are as mentioned above, and will not be repeated herein.

In some embodiments, the mixture may be polymerized at a polymerization temperature of 0 to 80°C. In some embodiments, the polymerization temperature may be 0 to 45°C, 0 to 40°C, 0 to 35°C, or 0 to 30°C. In some embodiments, the mixture may be polymerized for a reaction time of 1 to 8 hours. In some embodiments, the reaction time may be 2 to 7 hours.

The specific structure of the hydrocarbon resin polymer obtained according to the manufacturing method of a hydrocarbon resin polymer of the present disclosure is as described above, and will not be repeated herein. The hydrocarbon resin polymer obtained according to the manufacturing method of a hydrocarbon resin polymer of the present disclosure may have good electrical properties (dielectric properties). In some embodiments, the hydrocarbon resin polymer obtained according to the manufacturing method of a hydrocarbon resin polymer of the present disclosure may also have good thermal properties or processability.

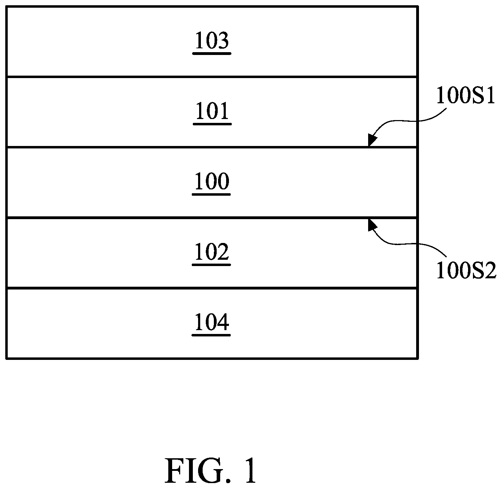

In some embodiments, the present disclosure provides a substrate structure. FIG. 1 is a schematic view of a substrate structure according to an embodiment of the present disclosure. Referring to FIG. 1, the substrate structure of the present disclosure includes a base layer 100, a conductive layer 103 disposed on the base layer 100, and a resin layer 101 disposed between the conductive layer 103 and the base layer 100. The resin layer 101 is formed from a resin composition including a hydrocarbon resin polymer above using a cross-linking process.

In some embodiments, the base layer 100 may include polyimide (PI), polycarbonate (PC), polyethylene terephthalate (PET), glass, quartz, sapphire, ceramic, plastic, Ajinomoto build-up Film (ABF), fiberglass paper, cotton paper, or a combination thereof, but the present disclosure is not limited thereto.

In some embodiments, the conductive layer 103 may include copper (Cu), aluminum (Al), molybdenum (Mo), tungsten (W), gold (Au), chromium (Cr), nickel (Ni), platinum (Pt), titanium (Ti), another suitable metal material, or any combination thereof, but the present disclosure is not limited thereto. In some embodiments, the conductive layer 103 may have a single-layer structure or a multi-layer stacked structure. For example, conductive layer 103 may include a single layer of metallic copper.

The base layer 100 may have a first surface 100S1 and a second surface 100S2 opposite to the first surface 100S1. The conductive layer 103 may be disposed on the first surface 100S1 of the base layer 100, and the resin layer 101 may be disposed between the first surface 100S1 of the base layer 100 and the conductive layer 103.

In some embodiments, the substrate structure may further include another conductive layer 104 on the second surface 100S2 of the base layer 100 and another resin layer 102 disposed between the second surface 100S2 of the base layer 100 and the conductive layer 104. The other resin layer 102 may include the same material as the resin layer 101. The other conductive layer 104 may include copper (Cu), aluminum (Al), molybdenum (Mo), tungsten (W), gold (Au), chromium (Cr), nickel (Ni), platinum (Pt), titanium (Ti), another suitable metal material, or any combination thereof, but the present disclosure is not limited thereto. In some embodiments, the other conductive layer 104 may have a single-layer structure or a multi-layer stacked structure. The other conductive layer 104 may include the same or different material and the same or different structure as the conductive layer 103. For example, the other conductive layer 104 may include a single layer of metallic copper.

The substrate structure having a resin layer including the hydrocarbon resin polymer of the present disclosure may have good electrical properties (dielectric properties). In some embodiments, the substrate structure having a resin layer above may also have good thermal properties, processability, and/or reliability.

One or more embodiments of the present disclosure will be described in detail with the following examples. However, these examples are used to illustrate the embodiments of the present disclosure and are not intended to limit the scope of the embodiments of the present disclosure.

### [Preparation of Hydrocarbon resin polymers 1 to 27]

### Hydrocarbon resin polymer 1

### Reaction Process

6.61 g (5 mol%) of a dicyclopentadiene (DCPD), 85.40 g (82 mol%) of a styrene, 16.92 g (13 mol%) of a divinylbenzene (DVB , purity of 63%, and the remaining 37% is an ethyl styrene), and 289 g of a toluene were added to a 1L four-neck vertical jacketed reactor under nitrogen atmosphere, and stirred using a four-wing flat blade with a stirring speed set to 400 rpm to form a mixture. A syringe pump was used to inject 2.84 g of boron trifluoride diethyl ether complex (BF₃-OEt₂) (the mole ratio of boron trifluoride diethyl ether complex: the mixture is 0.4:20) at a rate of 0.25 mL/min at a reaction temperature of 10°C. The polymerization reaction was terminated by adding 9.32 g of isopropanol after 3 hours of reaction time to obtain a polymer stock solution.

### Purification Process

First, the polymer stock solution was diluted with 100 g of toluene. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of the polymer stock solution. The solid-liquid phase was filtered by suction to obtain a white solid. The white solid was washed with methanol to remove impurities and isopropanol, and heated at 60 °C under nitrogen atmosphere to remove the solvent to obtain a white powder of hydrocarbon resin polymer as the hydrocarbon resin polymer 1. The yield was about 45%.

### Hydrocarbon resin polymer 2

### Reaction Process

15.23 g (11 mol%) of a dicyclopentadiene, 80.39 g (74 mol%) of a styrene, 19.5 g (15 mol%) of a divinylbenzene (purity of 63%, and the remaining 37% is an ethyl styrene), and 149.82 g of a toluene were added to a 1L four-neck vertical jacketed reactor under nitrogen atmosphere, and stirred using a four-wing flat blade with a stirring speed set to 400 rpm to form a mixture. A syringe pump was used to inject 2.94 g of boron trifluoride diethyl ether complex (the mole ratio of boron trifluoride diethyl ether complex: the mixture is 0.4:20) at a rate of 0.25 mL/min at a reaction temperature of 10°C. The polymerization reaction was terminated by adding 10.10 g of isopropanol after 3 hours of reaction time to obtain a polymer stock solution.

### Purification Process

First, the polymer stock solution was diluted with 94 g of toluene. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of the polymer stock solution. The solid-liquid phase was filtered by suction to obtain a white solid. The white solid was washed with methanol to remove impurities and isopropanol, and heated at 60 °C under nitrogen atmosphere to remove the solvent to obtain a white powder of hydrocarbon resin polymer as the hydrocarbon resin polymer 2. The yield was about 48%.

### Hydrocarbon resin polymer 3

### Reaction Process

17.27 g (17 mol%) of a dicyclopentadiene, 55.99 g (70 mol%) of a styrene, 13 g (13 mol%) of a divinylbenzene (purity of 63%, and the remaining 37% is an ethyl styrene), and 110.99 g of a toluene were added to a 1L four-neck vertical jacketed reactor under nitrogen atmosphere, and stirred using a four-wing flat blade with a stirring speed set to 400 rpm to form a mixture. A syringe pump was used to inject 1.09 g of boron trifluoride diethyl ether complex (the mole ratio of boron trifluoride diethyl ether complex: the mixture is 0.2:20) at a rate of 0.25 mL/min at a reaction temperature of 20°C. The polymerization reaction was terminated by adding 4.32 g of isopropanol after 5.5 hours of reaction time to obtain a polymer stock solution.

### Purification Process

First, the polymer stock solution was diluted with 52 g of toluene. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of the polymer stock solution. The solid-liquid phase was filtered by suction to obtain a white solid. The white solid was washed with methanol to remove impurities and isopropanol, and heated at 60 °C under nitrogen atmosphere to remove the solvent to obtain a white powder of hydrocarbon resin polymer as the hydrocarbon resin polymer 3. The yield was about 51%.

### Hydrocarbon resin polymer 4

### Reaction Process

21.6 g (17 mol%) of a dicyclopentadiene (purity of 95%), 70 g (70 mol%) of a styrene (purity of 99.8%), 16.25 g (13 mol%) of a divinylbenzene (purity of 63%, and the remaining 37% is an ethyl styrene), and 160 mL of a toluene were added to a 1L four-neck vertical jacketed reactor under nitrogen atmosphere, and stirred using a one layer four-wing flat blade with a stirring speed set to 400 rpm to form a mixture. A syringe pump was used to inject 2.73 g of boron trifluoride diethyl ether complex (the mole ratio of boron trifluoride diethyl ether complex: the mixture is 0.4:20) at a rate of 0.25 mL/min at a reaction temperature of 10°C. The polymerization reaction was terminated by adding 8.1 g of isopropanol after 2 hours of reaction time to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of polymer stock solution. The solid-liquid phase was filtered by suction to obtain a white solid. Redissolve the white solid in toluene to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer as the hydrocarbon resin polymer 4.

### Hydrocarbon resin polymer 5

### Reaction Process

34.53 g (17 mol%) of a dicyclopentadiene (purity of 95%), 111.99 g (70 mol%) of a styrene (purity of 99.8%), 26 g (13 mol%) of a divinylbenzene (purity of 63%, and the remaining 37% is an ethyl styrene), and 166.48 g of a toluene were added to a 1L four-neck vertical jacketed reactor under nitrogen atmosphere, and stirred using a four-wing flat blade with a stirring speed set to 400 rpm to form a mixture. A syringe pump was used to inject 2.18 g of boron trifluoride diethyl ether complex (the mole ratio of boron trifluoride diethyl ether complex: the mixture is 0.2:20) at a rate of 0.25 mL/min at a reaction temperature of 20°C. The polymerization reaction was terminated by adding 3.89 g of isopropanol after 4.5 hours of reaction time to obtain a polymer stock solution.

### Purification Process

First, the polymer stock solution was diluted with 75 g of toluene. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of the polymer stock solution. The solid-liquid phase was filtered by suction to obtain a white solid. The white solid was washed with methanol to remove impurities and isopropanol, and heated at 60 °C under nitrogen atmosphere to remove the solvent to obtain a white powder of hydrocarbon resin polymer as the hydrocarbon resin polymer 5.

### Hydrocarbon resin polymers 6 and 7

The hydrocarbon resin polymers 6 and 7 were obtained by the same reaction process and purification process as the hydrocarbon resin polymer 5, except that the reaction time is 5.5 hours and 6.5 hours instead of 4.5 hours, respectively.

### Hydrocarbon resin polymer 8

### Reaction Process

25.89 g (17 mol%) of a dicyclopentadiene, 83.99 g (70 mol%) of a styrene, 19.5 g (13 mol%) of a divinylbenzene (purity of 63%, and the remaining 37% is an ethyl styrene), and 66.60 g of a toluene were added to a 1L four-neck vertical jacketed reactor under nitrogen atmosphere, and stirred using a four-wing flat blade with a stirring speed set to 400 rpm to form a mixture. A syringe pump was used to inject 0.82 g of boron trifluoride diethyl ether complex (the mole ratio of boron trifluoride diethyl ether complex: the mixture is 0.1:20) at a rate of 0.25 mL/min at a reaction temperature of 20°C. The polymerization reaction was terminated by adding 3.77 g of isopropanol after 2 hours of reaction time to obtain a polymer stock solution.

### Purification Process

First, the polymer stock solution was diluted with 52 g of toluene. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of the polymer stock solution. The solid-liquid phase was filtered by suction to obtain a white solid. The white solid was washed with methanol to remove impurities and isopropanol, and heated at 60 °C under nitrogen atmosphere to remove the solvent to obtain a white powder of hydrocarbon resin polymer as the hydrocarbon resin polymer 8.

### Hydrocarbon resin polymers 9 to 12

The hydrocarbon resin polymers 9 to 12 were obtained by the same reaction process and purification process as the hydrocarbon resin polymer 8, except that the reaction time is 2.5 hours , 3 hours , 4 hours and 4.5 hours instead of 2 hours, respectively.

### Hydrocarbon resin polymer 13

### Reaction Process

20.30 g (20 mol%) of a dicyclopentadiene, 53.59 g (67 mol%) of a styrene, and 110.976 g of a toluene were added to a 400 mL five-neck vertical jacketed reactor under nitrogen atmosphere, and stirred using a four-wing flat blade with a stirring speed set to 400 rpm to form a mixture. A syringe pump was used to inject 4.36 g of boron trifluoride diethyl ether complex (the mole ratio of boron trifluoride diethyl ether complex: the mixture is 0.8:20) at a rate of 0.25 mL/min at a reaction temperature of 20°C. 13 g (13 mol%) of divinylbenzene (purity of 63%, and the remaining 37% is an ethyl styrene) was added after 0.5 hours. The polymerization reaction was terminated by adding 11.8 g of isopropanol after 1.5 hours of reaction time to obtain a polymer stock solution.

### Purification Process

First, the polymer stock solution was diluted with 53 g of toluene. The polymer stock solution was stirred using a mechanical stirrer with a rotation speed of 500 rpm. The polymer stock solution was slowly dropped into isopropanol through an addition funnel to obtain a light yellow crude resin product. The weight of isopropanol is 5 times the weight of the polymer stock solution. The solid-liquid phase was filtered by suction to obtain a light yellow solid. The light yellow solid was washed with methanol to remove impurities and isopropanol, and heated at 60 °C under nitrogen atmosphere to remove the solvent to obtain a light yellow powder of hydrocarbon resin polymer as the hydrocarbon resin polymer 13. The yield was about 72%.

### Hydrocarbon resin polymer 14

### Reaction Process

33.05 g (50 mol%) of a dicyclopentadiene, 9.50 g (18.25 mol%) of a styrene, 20.67 g (31.75 mol%) of a divinylbenzene (purity of 63%, and the remaining 37% is an ethyl styrene), 15.10 g of a butyl acetate, and 29.26 g of a toluene were added to a 400 mL five-neck vertical jacketed reactor under nitrogen atmosphere, and stirred using a four-wing flat blade with a stirring speed set to 400 rpm to form a mixture. A syringe pump was used to inject 1.42 g of boron trifluoride diethyl ether complex (the mole ratio of boron trifluoride diethyl ether complex: the mixture is 0.4:20) at a rate of 0.25 mL/min at a reaction temperature of 70°C. The polymerization reaction was terminated by adding 50 g of 5wt% aqueous sodium bicarbonate solution after 3 hours of reaction time to obtain a polymer stock solution.

### Purification Process

First, the polymer stock solution was diluted with 45 g of toluene. The polymer stock solution was stirred using a mechanical stirrer with a rotation speed of 500 rpm. The polymer stock solution was slowly dropped into isopropanol through an addition funnel to obtain a light yellow crude resin product. The weight of isopropanol is 5 times the weight of the polymer stock solution. The solid-liquid phase was filtered by suction to obtain a light yellow solid. 20 g of the crude product was dissolved in 40 g of toluene and stirred with a 50 mm stir bar at 200 rpm to obtain a polymer solution. The polymer solution was slowly dropped into isopropanol through an addition funnel to obtain a light yellow crude resin product. The weight of isopropanol is 5 times the weight of the polymer solution. The solid-liquid phase was filtered by suction to obtain a light yellow solid. The light yellow solid was washed with methanol to remove impurities and isopropanol, and heated at 60 °C under nitrogen atmosphere to remove the solvent to obtain a light yellow powder of hydrocarbon resin polymer as the hydrocarbon resin polymer 14.

### Hydrocarbon resin polymer 15

### Reaction Process

50.67 g (20 mol%) of a dicyclopentadiene (purity of 95%), 133.98 g (67 mol%) of a styrene (purity of 99.8%), 32.5 g (13 mol%) of a divinylbenzene (purity of 63%, and the remaining 37% is an ethyl styrene), and 320 mL of a toluene were added to a 1L four-neck vertical jacketed reactor under nitrogen atmosphere, and stirred using a one layer four-wing flat blade with a stirring speed set to 400 rpm to form a mixture. A syringe pump was used to inject 5.45 g of boron trifluoride diethyl ether complex (the mole ratio of boron trifluoride diethyl ether complex: the mixture is 0.4:20) at a rate of 0.25 mL/min at a reaction temperature of 10°C. After the addition of boron trifluoride diethyl ether complex, the reaction temperature was adjusted to 15°C and maintained for 2 hours. The polymerization reaction was terminated by adding 16.2 g of isopropanol to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of polymer stock solution. The solid-liquid phase was filtered by suction to obtain a white solid. Redissolve the white solid in toluene to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer. Redissolve the white powder of hydrocarbon resin polymer in tetrahydrofuran to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer as the hydrocarbon resin polymer 15.

### Hydrocarbon resin polymer 16

### Reaction Process

21.6 g (17 mol%) of a dicyclopentadiene (purity of 95%), 65.99 g (66 mol%) of a styrene (purity of 99.8%), 21.25 g (17 mol%) of a divinylbenzene (purity of 63%, and the remaining 37% is an ethyl styrene), and 160 mL of a toluene were added to a 1L four-neck vertical jacketed reactor under nitrogen atmosphere, and stirred using a one layer four-wing flat blade with a stirring speed set to 400 rpm to form a mixture. A syringe pump was used to inject 2.73 g of boron trifluoride diethyl ether complex (the mole ratio of boron trifluoride diethyl ether complex: the mixture is 0.4:20) at a rate of 0.25 mL/min at a reaction temperature of 0°C. Add boron trifluoride diethyl ether complex and wait for 2 hours, then add 8.1 g of isopropanol to terminate the polymerization reaction to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of polymer stock solution. The solid-liquid phase was filtered by suction to obtain a white solid. Redissolve the white solid in toluene to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer. Redissolve the white powder of hydrocarbon resin polymer in tetrahydrofuran to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer as the hydrocarbon resin polymer 16.

### Hydrocarbon resin polymer 17

### Reaction Process

43.15 g (17 mol%) of a dicyclopentadiene (purity of 95%), 129.98 g (65 mol%) of a styrene (purity of 99.8%), 44.99 g (18 mol%) of a divinylbenzene (purity of 63%, and the remaining 37% is an ethyl styrene), and 320 mL of a toluene were added to a 1L four-neck vertical jacketed reactor under nitrogen atmosphere, and stirred using a one layer four-wing flat blade with a stirring speed set to 400 rpm to form a mixture. A syringe pump was used to inject 5.45 g of boron trifluoride diethyl ether complex (the mole ratio of boron trifluoride diethyl ether complex: the mixture is 0.4:20) at a rate of 0.25 mL/min at a reaction temperature of 0°C. Add boron trifluoride diethyl ether complex and wait for 2 hours, then add 16.2 g of isopropanol to terminate the polymerization reaction to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of polymer stock solution. The solid-liquid phase was filtered by suction to obtain a white solid. Redissolve the white solid in toluene to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer. Redissolve the white powder of hydrocarbon resin polymer in tetrahydrofuran to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer as the hydrocarbon resin polymer 17.

### Hydrocarbon resin polymer 18

### Reaction Process

21.58 g (17 mol%) of a dicyclopentadiene (purity of 95%), 56.99 g (57 mol%) of a styrene (purity of 99.8%), 32.50 g (26 mol%) of a divinylbenzene (purity of 63%, and the remaining 37% is an ethyl styrene), and 160 mL of a toluene were added to a 1L four-neck vertical jacketed reactor under nitrogen atmosphere, and stirred using a one layer four-wing flat blade with a stirring speed set to 400 rpm to form a mixture. A syringe pump was used to inject 1.36 g of boron trifluoride diethyl ether complex (the mole ratio of boron trifluoride diethyl ether complex: the mixture is 0.2:20) at a rate of 0.25 mL/min at a low reaction temperature (0°C). Add boron trifluoride diethyl ether complex and wait for 2 hours, then add 4.1 g of isopropanol to terminate the polymerization reaction to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of polymer stock solution. The solid-liquid phase was filtered by suction to obtain a white solid. Redissolve the white solid in toluene to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer. Redissolve the white powder of hydrocarbon resin polymer in tetrahydrofuran to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer as the hydrocarbon resin polymer 18.

### Hydrocarbon resin polymer 19

### Reaction Process

20 g (100 mol%) of a dicyclopentadiene and 10.93 g of a toluene were added to a 100 mL three-neck reactor under nitrogen atmosphere, and stirred using a stir bar with a stirring speed set to 400 rpm to form a mixture. Injecting 0.43 g of boron trifluoride diethyl ether complex (the mole ratio of boron trifluoride diethyl ether complex: the mixture is 0.4:20) at one time at a reaction temperature of 25°C. The polymerization reaction was terminated by adding 1.39 g of isopropanol after 4.5 hours of reaction time to obtain a polymer stock solution.

### Purification Process

The polymer stock solution was stirred using a stir bar with a stirring speed set to 400 rpm and slowly dropped into isopropanol through an addition funnel to obtain a yellow crude resin product. The weight of isopropanol is 5 times the weight of polymer stock solution. The solid-liquid phase was filtered by suction to obtain a yellow solid. The light yellow solid was washed with methanol to remove impurities and isopropanol and then heated at 60 °C under vacuum to remove the solvent to obtain a yellow powder of hydrocarbon resin polymer as the hydrocarbon resin polymer 19. The yield was about 6%.

### Hydrocarbon resin polymer 20

### Reaction Process

20 g (55.6 mol%) of styrene (purity of 99.8%), 20 g (44.4 mol%) of divinylbenzene (purity of 63%, and the remaining 37% is an ethyl styrene), and 520.2 g of toluene were added to a 1000 mL five-neck vertical jacketed reactor under nitrogen atmosphere, and stirred using a four-wing flat blade with a stirring speed set to 400 rpm to form a mixture. A syringe pump was used to inject 2.185 g of boron trifluoride diethyl ether complex (the mole ratio of boron trifluoride diethyl ether complex: the mixture is 0.88:20) at a rate of 0.25 mL/min at a reaction temperature of 20°C. The polymerization reaction was terminated by adding 11.8 g of isopropanol after 3 hours of reaction time to obtain a polymer stock solution.

### Purification Process

First, the polymer stock solution was diluted with 260 g of toluene. The polymer stock solution was stirred using a mechanical stirrer with a rotation speed of 500 rpm. The polymer stock solution was slowly dropped into isopropanol through an addition funnel to obtain a light yellow crude resin product. The weight of isopropanol is 5 times the weight of the polymer stock solution. The solid-liquid phase was filtered by suction to obtain a light yellow solid. The light yellow solid was washed with methanol to remove impurities and isopropanol, and heated at 60 °C under nitrogen atmosphere to remove the solvent to obtain a light yellow powder of hydrocarbon resin polymer as the hydrocarbon resin polymer 20. The yield was about 40%.

### Hydrocarbon resin polymer 21

### Reaction Process

15 g (100 mol%) of divinylbenzene (purity of 63%, and the remaining 37% is an ethyl styrene) and 30 g of toluene were added to a 250 mL round bottom flask under nitrogen atmosphere at 25°C to form a mixture. 1.0 g of boron trifluoride diethyl ether complex (the mole ratio of boron trifluoride diethyl ether complex: the mixture is 0.12:20) was added at a reaction temperature of 10 °C, at which time the mixture will immediately change from colorless to yellow. The mixture was stirred at 10°C for 20 minutes, and then 1 mL of isopropanol was added to terminate the polymerization reaction to obtain a polymer stock solution.

### Purification Process

A light yellow polymer solution was precipitated from isopropanol (500 mL) to obtain a white powder. The resulting white powder was then dried at 60°C for 3 hours to obtain 9.8 g of the hydrocarbon resin polymer 21. The yield was about 65%.

### Hydrocarbon resin polymer 22

### Reaction Process

15 g (100 mol%) of styrene and 30 g of toluene were added to a 250 mL round bottom flask under nitrogen atmosphere at 25°C to form a mixture. 1.0 g of boron trifluoride diethyl ether complex (the mole ratio of boron trifluoride diethyl ether complex: the mixture is 0.2:20) was added at a reaction temperature of 10 °C, at which time the mixture will immediately change from colorless to yellow. The mixture was stirred at 10°C for 30 minutes, and then 1 mL of isopropanol was added to terminate the polymerization reaction to obtain a polymer stock solution.

### Purification Process

A light yellow polymer solution was precipitated from isopropanol (500 mL) to obtain a white powder. The resulting white powder was then dried at 60°C for 3 hours to obtain 8.3 g of the hydrocarbon resin polymer 22. The yield was about 55%.

### Hydrocarbon resin polymer 23

### Reaction Process

40 g (100 mol%) of a dicyclopentadiene and 10 g of a toluene were added to a 250 mL round bottom flask under nitrogen atmosphere at 25°C to form a mixture. 0.42 g of boron trifluoride diethyl ether complex (the mole ratio of boron trifluoride diethyl ether complex: the mixture is 0.2:20) was added, at which time the mixture will immediately change from colorless to brown. The mixture was stirred at 25°C for 24 hours, and then 1 mL of isopropanol was added to terminate the polymerization reaction to obtain a polymer stock solution.

### Purification Process

A brown polymer solution was precipitated from isopropanol (250 mL) to obtain a brown-orange powder. The resulting brown-orange powder was then dried at 60°C for 3 hours to obtain 20.0 g of the hydrocarbon resin polymer 23. The yield was about 50%.

### Hydrocarbon resin polymer 24

### Reaction Process

19.2 g (60 mol%) of styrene, 3.6 g (40 mol%) of divinylbenzene (purity of 63%, and the remaining 37% is an ethyl styrene), and 30 g of toluene were added to a 250 mL round bottom flask under nitrogen atmosphere to form a mixture. 0.7 g of boron trifluoride diethyl ether complex (the mole ratio of boron trifluoride diethyl ether complex: the mixture is 0.46:20) was added at a reaction temperature of 10 °C, at which time the mixture will immediately change from colorless to light yellow. The mixture was stirred at 10°C for 30 minutes, and then 1 mL of isopropanol was added to terminate the polymerization reaction to obtain a polymer stock solution.

### Purification Process

A light yellow polymer solution was precipitated from isopropanol (500 mL) to obtain a white powder. The resulting white powder was then dried at 60°C for 3 hours to obtain 14.8 g of the hydrocarbon resin polymer 24. The yield was about 65%.

### Hydrocarbon resin polymer 25

### Reaction Process

8.4 g (20 mol%) of a dicyclopentadiene, 19.9 g (60 mol%) of a styrene, 10.1 g (20 mol%) of a diisopropenylbenzene (IPAMS), and 100 g of a toluene were added to a 250 mL round bottom flask under nitrogen atmosphere to form a mixture. 0.36 g of boron trifluoride diethyl ether complex (the mole ratio of boron trifluoride diethyl ether complex: the mixture is 0.16:20) was added, at which time the mixture will immediately change from colorless to yellow. The mixture was stirred at 20°C for 3 hours, and then 1 mL of isopropanol was added to terminate the polymerization reaction to obtain a polymer stock solution.

### Purification Process

A yellow polymer solution was precipitated from isopropanol (600 mL) to obtain a white powder. The resulting white powder was then dried at 60°C for 3 hours to obtain 18.7 g of the hydrocarbon resin polymer 25. The yield was about 48.58%.

### Hydrocarbon resin polymer 26

### Reaction Process

25.38 g (20 mol%) of a dicyclopentadiene, 68.07 g (60 mol%) of a methyl styrene, 25 g (20 mol%) of a divinylbenzene (purity of 63%, and the remaining 37% is an ethyl styrene), and 320 mL of a toluene were added to a 1L four-neck vertical jacketed reactor under nitrogen atmosphere, and stirred using a one layer four-wing flat blade with a stirring speed set to 400 rpm to form a mixture. A syringe pump was used to inject 2.73 g of boron trifluoride diethyl ether complex (the mole ratio of boron trifluoride diethyl ether complex: the mixture is 0.4:20) at a rate of 0.25 mL/min at a reaction temperature of 0°C. After the addition of boron trifluoride diethyl ether complex, the reaction temperature was adjusted to 23°C. The polymerization reaction was terminated by adding 8.1 g of isopropanol after 3 hours of reaction time to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of polymer stock solution. The solid-liquid phase was filtered by suction to obtain a white solid. Redissolve the white solid in toluene to give another stock solution and perform a precipitation step with isopropanol (the weight ratio of the stock solution to isopropanol is 1:5). After filtration, a purer white resin solid was obtained. The white resin solid was washed with methanol to remove impurities and isopropanol and then heated and stirred under vacuum to remove the solvent to obtain a white powder of hydrocarbon resin polymer as the hydrocarbon resin polymer 26.

### Hydrocarbon resin polymer 27

### Reaction Process

9 g (44 mol%) of a norbornene (NB), 9.93 g (43 mol%) of a styrene, 3.73 g (13 mol%) of a divinylbenzene (purity of 63%, and the remaining 37% is an ethyl styrene), and 30 mL of a toluene were added to a 1L three-neck vertical jacketed reactor under nitrogen atmosphere, and stirred using astir bar with a stirring speed set to 400 rpm to form a mixture. After the addition of boron trifluoride diethyl ether complex, the reaction temperature was maintained at 0°C. The polymerization reaction was terminated by adding tetrahydrofuran after 2 hours of reaction time to obtain a colorless polymer stock solution.

### Purification Process

First, the polymer stock solution was filtered to remove impurities and insoluble matter. The polymer stock solution was stirred using a mechanical stirrer with a rotation speed of 500 rpm. The polymer stock solution was slowly dropped into isopropanol through an addition funnel to obtain a white crude resin product. The weight of isopropanol is 5 times the weight of polymer stock solution. The solid-liquid phase was filtered by suction to obtain a white solid. Redissolve the white solid in tetrahydrofuran to give another stock solution and perform a precipitation step with isopropanol (the weight ratio of the stock solution to isopropanol is 1:5).After filtration, a purer white resin solid was obtained. The white resin solid was washed with methanol to remove impurities and isopropanol and then heated and stirred under vacuum to remove the solvent to obtain a white powder of hydrocarbon resin polymer as the hydrocarbon resin polymer 27.

The material and proportion (based on the sum of the DCPD, the monovinyl aromatic compound, and the divinyl aromatic compound or the sum of the NB, the monovinyl aromatic compound, and the divinyl aromatic compound being 100 mol%) used to prepare the hydrocarbon resin polymers 1 to 27 are shown in Table 1 below. The polymerization time, the polymerization temperature, and the content of the fluorine-containing compound (boron trifluoride diethyl ether complex) are shown in Table 2 below.

**Table 1**

| Hydrocarbon resin polymer No. | DCPD (mol %) | Styrene (mol %) | Methyl styrene (mol %) | Ethyl styrene (mol %) | DVB (mol %) |
|---|---|---|---|---|---|
| 1 | 5 | 82 | 0 | 4.81 | 8.19 |
| 2 | 11 | 74 | 0 | 5.55 | 9.45 |
| 3 | 17 | 70 | 0 | 4.81 | 8.19 |
| 4 | 17 | 70 | 0 | 4.81 | 8.19 |
| 5 | 17 | 70 | 0 | 4.81 | 8.19 |
| 6 | 17 | 70 | 0 | 4.81 | 8.19 |
| 7 | 17 | 70 | 0 | 4.81 | 8.19 |
| 8 | 17 | 70 | 0 | 4.81 | 8.19 |
| 9 | 17 | 70 | 0 | 4.81 | 8.19 |
| 10 | 17 | 70 | 0 | 4.81 | 8.19 |
| 11 | 17 | 70 | 0 | 4.81 | 8.19 |
| 12 | 17 | 70 | 0 | 4.81 | 8.19 |
| 13 | 20 | 67 | 0 | 4.81 | 8.19 |
| 14 | 50 | 18.25 | 0 | 11.75 | 20 |
| 15 | 20 | 67 | 0 | 4.81 | 8.19 |
| 16 | 17 | 66 | 0 | 6.29 | 10.71 |
| 17 | 17 | 65 | 0 | 6.66 | 11.34 |
| 18 | 17 | 57 | 0 | 9.62 | 16.38 |
| 19 | 100 | 0 | 0 | 0 | 0 |
| 20 | 0 | 50 | 0 | 18.5 | 31.5 |
| 21 | 0 | 0 | 0 | 37 | 63 |
| 22 | 0 | 100 | 0 | 0 | 0 |
| 23 | 100 | 0 | 0 | 0 | 0 |
| 24 | 0 | 60 | 0 | 14.8 | 25.2 |
| 26 | 20 | 0 | 60 | 7.4 | 12.6 |

| Hydrocarbon resin polymer No. | DCPD (mol %) | Styrene (mol %) | Methyl styrene (mol %) | Ethyl styrene (mol %) | IPAMS (mol %) |
|---|---|---|---|---|---|
| 25 | 20 | 60 | 0 | 0 | 20 |

| Hydrocarbon resin polymer No. | NB (mol %) | Styrene (mol %) | Methyl styrene (mol %) | Ethyl styrene (mol %) | DVB (mol %) |
|---|---|---|---|---|---|
| 27 | 44 | 43 | 0 | 4.81 | 8.19 |

**Table 2**

| Hydrocarbon resin polymer No. | polymerization temperature (°C) | polymerization time | Content of Fluorine-containing compound |
|---|---|---|---|
| 1 | 10 | 3 Hours | 2 |
| 2 | 10 | 3 Hours | 2 |
| 3 | 20 | 5.5 Hours | 1 |
| 4 | 10 | 2 Hours | 2 |
| 5 | 20 | 4.5 Hours | 1 |
| 6 | 20 | 5.5 Hours | 1 |
| 7 | 20 | 6.5 Hours | 1 |
| 8 | 20 | 2 Hours | 0.5 |
| 9 | 20 | 2.5 Hours | 0.5 |
| 10 | 20 | 3 Hours | 0.5 |
| 11 | 20 | 4 Hours | 0.5 |
| 12 | 20 | 4.5 Hours | 0.5 |
| 13 | 20 | 1.5 Hours | 4 |
| 14 | 70 | 3 Hours | 2 |
| 15 | 10-15 | 2 Hours | 2 |
| 16 | 0 | 2 Hours | 2 |
| 17 | 0 | 2 Hours | 2 |
| 18 | 0 | 2 Hours | 2 |
| 19 | 25 | 4.5 Hours | 2 |
| 20 | 20 | 3 Hours | 4.4 |
| 21 | 10 | 20 Minutes | 1 |
| 22 | 10 | 30 Minutes | 1 |
| 23 | 25 | 24 Hours | 1 |
| 24 | 10 | 30 Minutes | 1 |
| 25 | 20 | 3 Hours | 0.8 |
| 26 | 0-23 | 3 Hours | 1 |
| 27 | 0-23 | 4 Hours | 2 |

The content of the fluorine-containing compound listed in Table 2 above is, based on the sum of raw materials listed in Table 1 being 100 moles, the mole ratio of the sum of the raw materials listed in Table 1: the fluorine-containing compound. For example, in Table 2, the content of the fluorine-containing compound of the hydrocarbon polymer 1 is 2, indicating that the molar ratio of the sum of the DCPD, the monovinyl aromatic compound and the divinyl aromatic compound of the hydrocarbon polymer 1 listed in Table 1: the fluorine-containing compound is 100:2.

### [Structural analysis of the hydrocarbon resin polymers 1 to 27]

The structural compositions of the hydrocarbon resin polymers 1 to 27 were analyzed by a nuclear magnetic resonance (NMR, JEOL, JNM-ECZ400S) through ¹³C-NMR and ¹H-NMR. It is understood that the hydrocarbon resin polymers 1 to 27 includes a repeating unit (A) derived from a dicyclopentadiene, a repeating unit (B) derived from a monovinyl aromatic compound, and a repeating unit (C) derived from a divinyl aromatic compound. Table 3 reveals, based on the sum of the repeating unit (A), the repeating units (B), and the repeating units (C) being 100 mol%, the content of the repeating unit (A), the content of the repeating units (B), the content of the repeating units (C), and the sum of the content of the repeating unit (A) and the repeating unit (C) of the hydrocarbon resin polymers 1 to 13 and 15 to 24.

**Table 3**

| Hydrocarbon resin polymer No. | Content of repeating unit (A) (mol%) | Content of repeating unit (B) (mol%) | Content of repeating unit (C) (mol%) | Sum of content of repeating unit (A) and repeating unit (C) (mol%) |
|---|---|---|---|---|
| 1 | 2 | 87 | 11 | 13 |
| 2 | 3 | 81 | 16 | 19 |
| 3 | 2 | 79 | 18 | 20 |
| 4 | 5 | 77 | 17 | 22 |
| 5 | 2 | 85 | 13 | 15 |
| 6 | 2 | 85 | 13 | 15 |
| 7 | 2 | 82 | 16 | 18 |
| 8 | 2 | 80 | 18 | 20 |
| 9 | 2 | 80 | 20 | 22 |
| 10 | 2 | 80 | 18 | 20 |
| 11 | 2 | 78 | 20 | 22 |
| 12 | 2 | 79 | 19 | 21 |
| 13 | 5 | 76 | 19 | 24 |
| 14 | Not measured | | | |
| 15 | 4 | 79 | 18 | 22 |
| 16 | 3 | 78 | 19 | 23 |
| 17 | 3 | 77 | 19 | 23 |
| 18 | 2 | 73 | 25 | 27 |
| 19 | 100 | 0 | 0 | 100 |
| 20 | 0 | 53 | 48 | 48 |
| 21 | 0 | 37 | 63 | 63 |
| 22 | 0 | 100 | 0 | 0 |
| 23 | 100 | 0 | 0 | 100 |
| 24 | 0 | 72 | 29 | 29 |
| 25 | Not measured | | | |
| 26 | Not measured | | | |
| 24 | Not measured | | | |

### [Measurements of Physical/Chemical Properties of the hydrocarbon resin polymers 1 to 27]

### [Measurement of Hydrogen Content on Reactive Double Bond]

The hydrocarbon resin polymers 1 to 27 were dissolved in a deuterated chloroform (CDCl₃), respectively. The hydrogen content on the reactive double bond in the hydrocarbon resin polymers 1 to 27 was measured by NMR (JEOL, JNM-ECZ400S/L1), respectively. In particular, the hydrogen contents on the reactive double bond in the hydrocarbon resin polymers 1 to 27 were calculated by dividing the sum of the integrated values of the hydrogens on the reactive double bond by the sum of the integrated values of all hydrogens.

### [Measurement of Number Average Molecular Weight (Mn) and Polymer Dispersity Index (PDI)]

Using polystyrene as a standard, the number average molecular weights (Mn) and polymer dispersion indexes (PDI) of the hydrocarbon resin polymers 1 to 27 were measured through gel permeation chromatography (GPC) (Waters APC, column: Waters Acquity XT 900).

In particular, 5 mL of tetrahydrofuran (THF) was added to 0.01 g of the hydrocarbon resin polymers 1 to 27, respectively, to prepare the samples of the hydrocarbon resin polymers 1 to 27. The samples of the hydrocarbon resin polymers 1 to 27 were filtered with a 0.22 µm filter and analyzed with instruments to obtain the number average molecular weights (Mn) and polymer dispersion indexes (PDI) of the hydrocarbon resin polymers 1 to 27.

### [Measurement of Content of Cross-linkable Repeating Unit (C1)]

The structures of the hydrocarbon resin polymers 1 to 27 were analyzed by NMR (JEOL, JNM-ECZ400S/L1) and GPC (Waters). CDCl₃ was used as the solvent and the resonance line of CDCl₃ was used as the internal standard to obtain the content of the cross-linkable repeating unit (C1) in the hydrocarbon resin polymers 1 to 27.

The number average molecular weight (Mn), polymer dispersion index (PDI), hydrogen content on reactive double bond, and content of the cross-linkable repeating unit (C 1) of the hydrocarbon resin polymers 1 to 27 are shown in Table 4 below.

**Table 4**

| Hydrocarbon resin polymer No. | Number average molecular weight (Mn)(g/mol) | Polymer dispersion index (PDI) | Content of cross-linkable repeating unit (C1) (mol%) | Hydrogen content on reactive double bond (%) |
|---|---|---|---|---|
| 1 | 7860 | 6.74 | 8 | 2.28 |
| 2 | 8250 | 14.99 | 12 | 2.47 |
| 3 | 6305 | 6.66 | 10 | 2.79 |
| 4 | 6368 | 9.53 | 10 | 3.38 |
| 5 | 6407 | 6 | 10 | 2.76 |
| 6 | 6322 | 6.74 | 8 | 2.34 |
| 7 | 6911 | 9.52 | 9 | 2.66 |
| 8 | 6423 | 4.56 | 13 | 3.34 |
| 9 | 7475 | 4.78 | 13 | 3.33 |
| 10 | 6276 | 6.82 | 12 | 3.2 |
| 11 | 6528 | 10.13 | 11 | 3.01 |
| 12 | 6919 | 13.16 | 12 | 3.07 |
| 13 | 3462 | 5.7 | 6 | 2.58 |
| 14 | 4058 | 17.7 | Not measured | 5.64 |
| 15 | 7787 | 5.04 | 11 | 3.24 |
| 16 | 10480 | 8.5 | 12 | 3.22 |
| 17 | 12159 | 8.33 | 12 | 2.95 |
| 18 | 14955 | 10.06 | 20 | 3.49 |
| 19 | 929 | 1.4 | 0 | 9.85 |
| 20 | 4082 | 2.55 | 31 | 11.6 |
| 21 | 2038 | 15.1 | 52 | 12.5 |
| 22 | 5517 | 7 | 0 | 0 |
| 23 | 793 | 1.8 | 0 | 13.7 |
| 24 | 4613 | 12.91 | 29 | 6.936 |
| 25 | 7359 | 21.9 | Not measured | 2 |
| 26 | 9087 | 9.42 | Not measured | 3.1 |
| 27 | 6237 | 15.13 | Not measured | 2 |

### [Test of Electrical Performance of Hydrocarbon resin polymer]

20 g of the hydrocarbon resin polymers 1, 2, 4, 13, 15, 16, 17, and 20 were dissolved in 20 g of toluene to form a mixture. The mixture is stirred until the hydrocarbon resin polymers therein is completely dissolved to form hydrocarbon resin polymer solutions 1, 2, 4, 13, 15, 16, 17, and 20. Glass fiber cloths (Asahi 2116, Dk/Df=3.3/0.0030@ 28GHz) were dipped in the hydrocarbon resin polymer solutions 1, 2, 4, 13, 15, 16, 17, and 20 for 16 hours and baked at 170°C for 10 minutes to form samples of 1, 2, 4, 13, 15, 16, 17, and 20, respectively. The weight of the samples were measured using a network analyzer software (network analyzer Keysight, P5007A, SCR). Measure the Dk/Df and R.C. % of the samples at 28GHz, and results are shown in Table 5 below. Here, R.C.% represents the resin content. R.C. %=(weight after baking-weight of glass fiber cloth)/weight after baking* 100%.

**Table 5**

| Hydrocarbon resin polymer No. | Dk/Df@28 GHz | R.C. % |
|---|---|---|
| 1 | 2.65/0.00162 | 62.37% |
| 2 | 2.49/0.00113 | 75.13% |
| 4 | 3.057/0.001837 | 58.8% |
| 15 | 2.95/0.001804 | 61.4% |
| 16 | 3.11/0.00165 | 63.68% |
| 17 | 2.89/0.0016 | 69.9% |
| 20 | 2.710/0.0019081 | 61.90% |

### [Measurement of Content of Fluorine substituent]

Preparation of an internal standard solution: Dissolve 2.9 mg of trifluorotoluene (TFT, internal standard) in 4507.9 mg of CDCl₃ to form an internal standard solution (TFT content 0.0643%).

Preparation of Samples: 5 g of the hydrocarbon resin polymers 1 to 27 were added to about 1.1 g of the above internal standard solution and subjected to ultrasonic shaking for 10 minutes. After the hydrocarbon resin polymers 1 to 27 were dissolved, the samples were transferred to an NMR tube (NMR tube, JEOL/JNM-ECZ400S/L1) and analyzed under a test environment at 25°C. The ¹⁹F NMR spectrum of the hydrocarbon resin polymers 1 to 27 were obtained.

Based on the obtained ¹⁹F NMR spectrum of the hydrocarbon resin polymer, the content of the fluorine substituent of the hydrocarbon resin polymers 1 to 27 are calculated using the following formula: Content of fluorine substituent (ppm)=(trifluorotoluene (g))/146.11×19×Integral value of fluoride ions ÷ Weight of hydrocarbon resin polymer(g)×1,000,000, the integral value of fluoride ions in the formula above is the sum of the areas of all peaks in a range of-125 ppm to -230 ppm in the obtained ¹⁹F NMR spectrum.

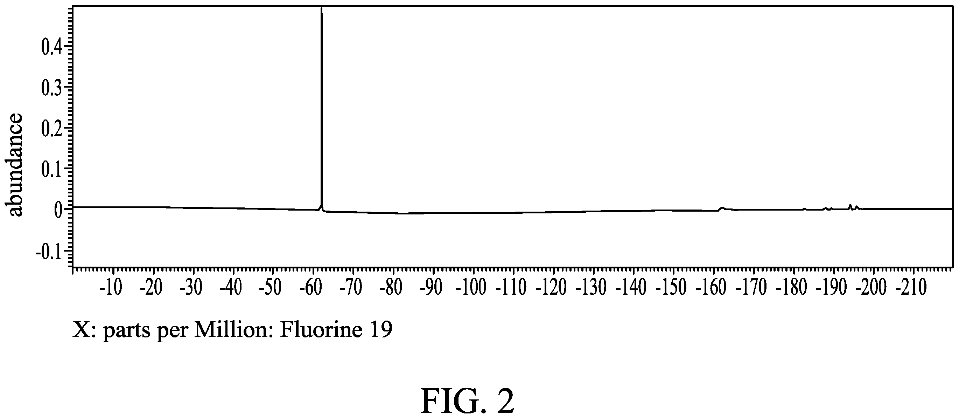

For example, FIG. 2 is the ¹⁹F NMR spectrum of a hydrocarbon resin polymer 15. The content of the fluorine substituent of the hydrocarbon polymer 15 was obtained by the formula above based on the integral value of fluoride ions calculated by summing the areas of all peaks in a range of -125 ppm to -230 ppm in the ¹⁹F NMR spectrum shown in FIG. 2.

The average number of fluorine substituents of the hydrocarbon resin polymers1 to 19 were calculated based on the content of the fluorine substituent of the hydrocarbon resin polymers 1 to 19 and the number average molecular weight of the hydrocarbon resin polymers 1 to 19. Specifically, the average number of fluorine substituents per molecule of the hydrocarbon resin polymers of the present disclosure is calculated using the following formula: Average number of fluorine substituents per molecule of the hydrocarbon resin polymers =((Content of the fluorine substituent (ppm)× 0.001)/19)/(1000/(Number average molecular weight of the hydrocarbon resin polymer (g/mol)))

The contents of fluorine substituents of hydrocarbon polymers 1 to 19 calculated above and the average number of fluorine substituents per molecule of the hydrocarbon polymers are listed in Table 6 below.

**Table 6**

| Hydrocarbon resin polymer No. | Content of fluorine substituent (ppm) | Average number of fluorine substituents per molecule of the hydrocarbon resin polymer (number / molecule) |
|---|---|---|
| 1 | 120 | 0.049642105 |
| 2 | 308 | 0.133736842 |
| 3 | 369 | 0.122449737 |
| 4 | 344 | 0.115294316 |
| 5 | 243 | 0.081942158 |
| 6 | 237 | 0.078858632 |
| 7 | 113 | 0.041102263 |
| 8 | 493 | 0.166659947 |
| 9 | 432 | 0.169957895 |
| 10 | 428 | 0.141375158 |
| 11 | 355 | 0.121970526 |
| 12 | 356 | 0.129640211 |
| 13 | 197 | 0.035895474 |
| 14 | 85 | 0.124943684 |
| 15 | 334.7 | 0.137174153 |
| 16 | 599.7 | 0.330781895 |
| 17 | 649.6 | 0.415709811 |
| 18 | 595 | 0.468327632 |
| 19 | 4415 | 0.215870263 |
| 20 | No substituents present | -- |
| 21 | No substituents present | -- |
| 22 | No substituents present | -- |
| 23 | Substituent present | Not calculated |
| 24 | No substituents present | -- |
| 25 | Substituent present | Not calculated |
| 26 | Substituent present | Not calculated |
| 27 | No substituents present | -- |

According to Table 6 above, the hydrocarbon resin polymers 20, 21, 22, and 24 do not have fluorine substituents. Further, the hydrocarbon resin polymer 27 polymerized from norbornene instead of dicyclopentadiene does not have fluorine substituent. It is apparent that dicyclopentadiene and fluorine-containing compounds are necessary for the preparation of hydrocarbon resin polymers having fluorine substituent.

According to Table 5 and Table 6, the hydrocarbon resin polymers having fluorine substituent have a lower loss factor (Df). It is apparent that the hydrocarbon resin polymers having fluorine substituent will have better electrical performance.

Furthermore, according to Table 4, all of the hydrocarbon resin polymers 1 to 19, 23, 25, and 26 have a polymer dispersion indexes (PDI) of less than 22, a number average molecular weight (Mn) of from 2,500 to 15,000 g/mol, and a hydrogen content of the reactive bonds of greater than 0.2%. The hydrocarbon resin polymers 1 to 19, 25, and 26 all have a hydrogen content of the reactive bonds of less than 10 %. It is apparent that in some embodiments, the hydrocarbon resin polymers of the present disclosure, in addition to having better electrical properties, may also have good thermal properties or processability. The resin composition including the hydrocarbon resin polymer of the present disclosure may form a resin layer having good peel strength. The substrate structure including the above resin layer may have good electrical performance (dielectric properties). In some embodiments, the substrate structure including the resin layer may also have good thermal performance, processability, and/or reliability.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A hydrocarbon resin polymer, comprising:
a repeating unit (A), derived from dicyclopentadiene (DCPD),
wherein the hydrocarbon resin polymer has a fluorine substituent, and the content of the fluorine substituent is 100 to 4500 ppm based on the total weight of the hydrocarbon resin polymer.

2. The hydrocarbon resin polymer as claimed in claim 1, wherein the hydrocarbon resin polymer has an average of 0.02 to 2 fluorine substituents per molecule.

3. The hydrocarbon resin polymer as claimed in claim 1, wherein the number average molecular weight (Mn) of the hydrocarbon resin polymer is in a range of 500 to 15,000 g/mol.

4. The hydrocarbon resin polymer as claimed in claim 1, further comprising:
a repeating unit (B), derived from a monovinyl aromatic compound; and
a repeating unit (C), derived from a divinyl aromatic compound.

5. The hydrocarbon resin polymer as claimed in claim 4, wherein based on the sum of all units in the hydrocarbon resin polymer being 100 mol%, the hydrocarbon resin polymer comprises 0.15 to 15 mol% of repeating unit (A), 14 to 95 mol% of repeating unit (B), and 4 to 85 mol% of repeating unit (C).

6. The hydrocarbon resin polymer as claimed in claim 1, wherein a ¹⁹F NMR spectrum of the hydrocarbon resin polymer has peaks in a range of -125 ppm to -230 ppm.

7. A manufacturing method of a hydrocarbon resin polymer, comprising:
polymerizing a mixture in the presence of a fluorine-containing compound, wherein the fluorine-containing compound is a boron trifluoride complex and the mixture comprises dicyclopentadiene.

8. The manufacturing method of a hydrocarbon resin polymer as claimed in claim 7, wherein the boron trifluoride complex comprises boron trifluoride tetrahydrofuran complex (BF₃ · THF), boron trifluoride methanol complex (BF₃ · MeOH), boron trifluoride hydrate (BF₃· H₂O), boron trifluoride diethyl ether complex (BF₃· OEt₂), boron trifluoride -anisole complex (BF₃· PhOMe), boron trifluoride acetic acid complex (BF₃· AcOH), or any combination thereof.

9. The manufacturing method of a hydrocarbon resin polymer as claimed in claim 7, wherein a mole ratio of the fluorine-containing compound: the mixture is 0.01 to 1:20.

10. The manufacturing method of a hydrocarbon resin polymer as claimed in claim 7, wherein the mixture further comprises a monovinyl aromatic compound and/or a divinyl aromatic compound.

11. The manufacturing method of a hydrocarbon resin polymer as claimed in claim 7, wherein based on the sum of all components in the mixture being 100 mol%, the mixture comprises 3 to 80 mol% of dicyclopentadiene, 0 to 90 mol% of the monovinyl aromatic compound, and 0 to 50 mol% of the divinyl aromatic compound.

12. A substrate structure, comprising:
a resin layer, and
a conductive layer disposed on the resin layer;
wherein the resin layer is formed from a resin composition using a cross-linking process, and the resin composition comprises a hydrocarbon resin polymer, the hydrocarbon resin polymer has a fluorine substituent and comprises:
a repeating unit (A), derived from dicyclopentadiene (DCPD),
wherein the content of the fluorine substituent is 100 to 4500 ppm based on the total weight of the hydrocarbon resin polymer.

13. The substrate structure as claimed in claim 12, wherein the hydrocarbon resin polymer has an average of 0.02 to 2 fluorine substituents per molecule.

14. The substrate structure as claimed in claim 12, wherein the hydrocarbon resin polymer further comprises:
a repeating unit (B), derived from a monovinyl aromatic compound; and
a repeating unit (C), derived from a divinyl aromatic compound.

15. The substrate structure as claimed in claim 14, wherein based on the sum of all units in the hydrocarbon resin polymer being 100 mol%, the hydrocarbon resin polymer comprises 0.15 to 15 mol% of repeating unit (A), 14 to 95 mol% of repeating unit (B), and 4 to 85 mol% of repeating unit (C).
